Europäisches Patentamt

European Patent Office

Office européen des brevets

(11) Numéro de publication: **0 480 804 B1**

# FASCICULE DE BREVET EUROPEEN

(45) Date de publication de fascicule du brevet: **04.01.95**   (51) Int. Cl.6: **C30B 25/18**, H01L 21/20

(21) Numéro de dépôt: **91402652.1**

(22) Date de dépôt: **04.10.91**

(54) **Procédé de croissance de couches hétéroépitaxiales.**

(30) Priorité: **09.10.90 FR 9012443**

(43) Date de publication de la demande:
**15.04.92 Bulletin 92/16**

(45) Mention de la délivrance du brevet:
**04.01.95 Bulletin 95/01**

(84) Etats contractants désignés:
**DE GB IT NL**

(56) Documents cités:
**EP-A- 0 336 830**
**EP-A- 0 336 831**
**US-A- 4 948 456**

(73) Titulaire: **THOMSON-CSF**
**173, Boulevard Haussmann**
**F-75008 Paris (FR)**

(72) Inventeur: **Pribat, Didier**
**THOMSON-CSF,**
**SCPI,**
**Cédex 67**
**F-92045 Paris la Défense (FR)**
Inventeur: **Legagneux, Pierre**
**THOMSON-CSF,**
**SCPI,**
**Cédex 67**

**F-92045 Paris la Défense (FR)**
Inventeur: **Collet, Christian**
**THOMSON-CSF,**
**SCPI,**
**Cédex 67**
**F-92045 Paris la Défense (FR)**
Inventeur: **Provendier, Valérie**
**THOMSON-CSF,**
**SCPI,**
**Cédex 67**
**F-92045 Paris la Défense (FR)**

(74) Mandataire: **Guérin, Michel et al**
**THOMSON-CSF**
**SCPI**
**B.P. 329**
**50, rue Jean-Pierre Timbaud**
**F-92402 Courbevoie Cédex (FR)**

# Description

L'invention concerne un procédé de réalisation de couches hétéroépitaxiales, plus précisément un procédé de réalisation d'au moins une couche mince d'un matériau semiconducteur sur un substrat semiconducteur d'un type différent.

L'invention a trait au domaine des "couches minces" et particulièrement au domaine des couches minces monocristallines épitaxiées sur un substrat de nature différente.

L'invention sera de préférence appliquée à la croissance de couches de GaAs sur Si, et elle permet d'éliminer par blocage les dislocations générées à l'interface cristal/substrat.

Lors de la croissance hétéropitaxiale de GaAs sur Si, des dislocations sont générées à l'interface cristal/substrat, qui se propagent dans la couche mince au cours du dépôt. De façon très schématique, la présence de ces dislocations est due à la fois à la différence entre les paramètres de maille de Si (0,54 nm) et GaAs (0,56 nm) et à la différence entre les coefficients d'expansion thermique (2,3 $10^{-6} . °C^{-1}$ pour Si contre 5.6 $10^{-6} °C^{-1}$ pour GaAs).

Ces dislocations une fois nucléées sont pratiquement impossible à éliminer au cours d'une croissance normale de type MBE ou MOCVD, ce qui limite considérablement le champ d'application des hétéroépitaxies de GaAs sur Si.

En effet, les dislocations, agissant comme des centres de recombinaison, diminuent de façon drastique la durée de vie des porteurs minoritaires. Il en résulte qu'il est pratiquement impossible de réaliser dans les couches hétéroépitaxiées de GaAs sur Si des composants bipolaires tels que lasers et photodiodes par exemple.

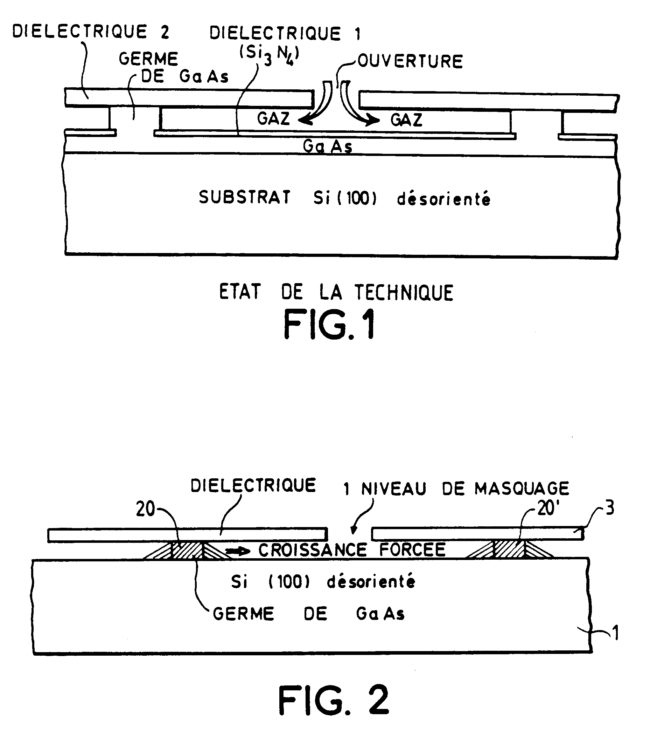

Un procédé de blocage des dislocations a été mis au point (voir la demande de brevet français n° 88 044 38 déposée le 5 avril 1988). Ce procédé permet d'obtenir des couches pratiquement exemptes de défauts. Le principe de ce procédé (dit de croissance forcée) est représenté sur la figure 1. Un des inconvénients du procédé est qu'il nécessite l'utilisation de deux niveaux de diélectrique et de deux niveaux de masquage pour réaliser les bandes de germination d'une part, et les bandes permettant l'accès du gaz de la phase d'épitaxie forcée d'autre part (voir figure 1).

La présente invention permet de simplifier considérablement le procédé ci-dessus en le limitant à une seule couche de diélectrique et à un seul niveau de masquage.

L'invention concerne donc un procédé de réalisation par croissance en phase vapeur sur un substrat en matériau semiconducteur d'un premier type d'une couche mince monocristalline d'un matériau semiconducteur d'un deuxième type, caractérisé en ce que la croissance est initiée sur au moins un germe de composition chimique identique au matériau semiconducteur du deuxième type de la couche mince à obtenir, et est confinée dans un espace défini par une face du substrat lui-même et une couche de confinement en matériau différent du matériau semiconducteur du deuxième type de telle façon qu'il ne peut y avoir ni nucléation ni dépôt de matériau semiconducteur sur cette couche de confinement, ni sur ladite face du substrat, l'espace de confinement définissant l'épaisseur de la couche mince monocristalline de semiconducteur à obtenir.

Les différents objets et caractéristiques de l'invention apparaîtront plus clairement dans la description qui va suivre et dans les dessins annexés qui représentent :

- la figure 1, une illustration de l'état de la technique déjà décrit précédemment ;
- la figure 2, un schéma de base du procédé de réalisation de l'invention ;
- les figures 3a à 3f, différentes étapes du procédé de réalisation selon l'invention ;
- les figures 4a à 4f, différentes étapes d'un perfectionnement du procédé de l'invention ;
- la figure 5, une structure intermédiaire du procédé de l'invention ;
- la figure 6, une phase supplémentaire d'une variante du procédé de réalisation selon l'invention ;
- les figures 7 et 8, des phases de réalisation résultant de la phase de la figure 6 ;
- les figures 9 à 11, des phases de réalisation d'une autre variante du procédé de l'invention.

Le principe de la méthode est représenté sur la figure 2.

La faisabilité de cette méthode provient du fait que l'on a constaté que le GaAs déposé par une méthode VPE du type $AsCl_3 + Ga$ (méthode dite des trichlorures) ne nucléait pas sur les surfaces libres de silicium.

L'invention sera décrite en s'appuyant sur l'exemple de GaAs hétéroépitaxié sur Si, mais, son cadre d'application est beaucoup plus large ; il suffit en effet pour pouvoir appliquer la présente méthode en cas de l'hétéroépitaxie d'un matériau A sur un matériau B, d'utiliser une méthode de dépôt permettant de supprimer (au moins temporairement) la nucléation de A sur B ou de prévoir un matériau B sur lequel il ne puisse y avoir ni nucléation, ni dépôt du matériau A.

L'invention sera donc mieux comprise à la lecture de la description qui va suivre.

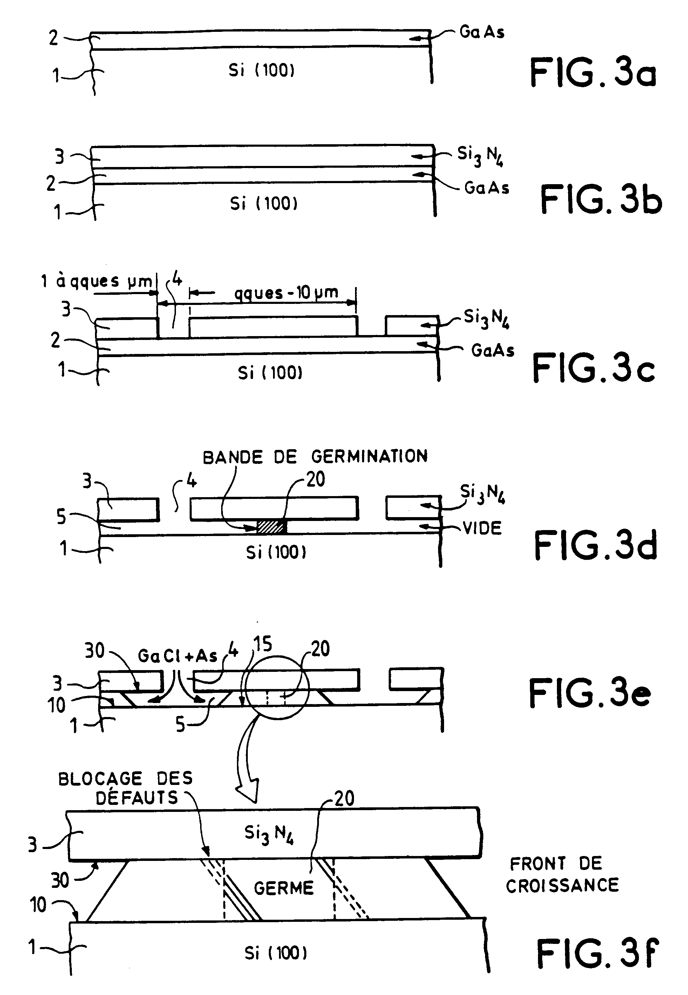

- On réalise sur un substrat 1 de départ, en silicium (100) une couche mince 2 de GaAs (épaisseur 0,5 à 1 $\mu$m typiquement ), ( voir figure 3a ).

Il n'est pas forcément nécessaire d'utiliser une plaquette légèrement désorientée vers la direction ⟨110⟩, car les défauts de type parois d'antiphase seront aussi bloqués comme on le verra dans la suite. Cette opération préliminaire d'hétéroépitaxie peut s'effectuer par MBE (Molecular Beam Epitaxy) par MOCVD (Metal Organic Chemical Vapor Deposition) par MOMBE (Metal Organic Molecular Beam Epitaxy) par CBE (Chemical Beam Epitaxy) etc ...

On sait (voir par exemple l'article de revue de H. KROEMER dans l'ouvrage : "Heteroépitaxy on Silicon" édité par FAN et POATE, MRS Symposia Proceedings n° 67, Pittsburgh PA, 1986) que les couches de GaAs réalisées par des procédés tels que ceux cités ci-dessus contiennent dans le meilleur des cas environ $10^6$ dislocations par $cm^2$. Elles peuvent aussi contenir des micromacles et des parois d'antiphase selon les conditions de croissance. Il est bien sûr impossible de fabriquer des lasers et des photodiodes dans des couches comprenant une telle densité de défauts.

- On dispose, sur la couche 2 de GaAs, une couche uniforme 3 de $Si_3N4$ d'épaisseur typiquement de l'ordre de 0,3 à 0,9 $\mu m$ (figure 3b). On a choisi le $Si_3N_4$ dans cet exemple de réalisation mais ce pourrait être tout autre matériau sur lequel il ne pourra y avoir ni nucléation, ni dépôt du matériau (GaAs selon l'exemple pris) qui va être épitaxié dans ce qui va suivre
- On grave dans cette couche 3 de $Si_3N_4$ une série d'ouvertures 4 se présentant sous la forme de bandes parallèles équidistantes.

L'ouverture de ces bandes est de l'ordre de un à quelques micromètres et le pas de répétition est typiquement de quelques dizaines de micromètres, pouvant aller jusqu'à plusieurs centaines de $\mu m$ (voir figure 3c).

Ces bandes sont orientées de façon à ce que lors de la croissance latérale qui sera réalisée ci-après, il n'apparaisse pas de facette ce croissance unique du type (111), qui aurait pour effet de limiter la vitesse de croissance latérale. On évitera donc pour ces bandes les orientations de type ⟨110⟩ et ⟨1$\overline{1}$0⟩. On a constaté, qu'une famille l'orientations donnant satisfaction est comprise entre 15 et 30 degrés par exemple 22,5°, de part et d'autre des directions ⟨110⟩ et ⟨1$\overline{1}$0⟩ précitées. Ceci n'est toutefois pas limitatif et on peut être amené à utiliser une orientation de type ⟨110⟩ exacte si l'on veut introduire des facettes de type (111) ou (110).

- On immerge la structure de la figure 3C dans un réactif d'attaque chimique du matériau de la couche 2. Par exemple, un mélange de $H_2O_2$ et $H_2SO_4$ convient de façon à éliminer de manière sélective une partie de la couche mince 2 de GaAs hétéroépitaxiée. Cependant on arrête l'attaque de la couche 2 de façon à conserver une partie centrale 20 qui sert de support à la couche 3 de $Si_3N_4$ et qui va servir de germe lors de l'opération de croissance qui va suivre. On obtient ainsi la structure de la figure 3d.

- On introduit la structure de la figure 3d dans un réacteur par exemple de type VPE utilisant comme sources de l'$AsCl_3$ et du Ga. Dans des conditions normales de dépôt, c'est-à-dire lorsque la source de Ga est maintenue vers 850°C, que la fraction molaire de As $Cl_3$ est de l'ordre de $10^{-3}$ et que le substrat est maintenu aux alentours de 750°C, on constate qu'il y a nucléation et croissance de GaAs sur le germe central 20, mais par contre, on n'observe ni nucléation ni croissance à la fois sur les surfaces exposées de la couche 3 de $Si_3N_4$, ni sur le substrat 1 en Si (100).

On peut obtenir un effet similaire de croissance sélective en utilisant un réacteur de type MOCVD avec des précurseurs non plus de la forme triethyl ou trimethyl gallium, mais incorporant des chlorures, c'est-à- dire des précurseurs tels que diethylgallium chlorure $(C_2H_5)_2$ GaCl ( voir par exemple le document KUECH et all. Proceding of the 5th International Conference on MOVPE, AACHEN, Germany 18-22 juin 1990).

La croissance à partir du germe central 20 de GaAs s'effectue donc de la façon représentée à la figure 3e, entre la surface du substrat Si (100) et la surface inférieure de la couche 3 de $Si_3N_4$, sans qu'il y ait nucléation sur Si et $Si_3N_4$.

On observe ici une phénomène de blocage de tous les défauts qui ne sont pas strictement parallèles aux interfaces GaAs/$Si_3N_4$ (dislocations, micromacles et parois d'antiphase). Ce blocage s'effectue soit sur la face inférieure 30 de la couche 3, soit sur la surface du substrat 1 en Si (100) comme cela est représenté sur la figure 3f). Une fois les défauts bloqués, la croissance se poursuit normalement de part et d'autre du germe central 20, le cristal obtenu étant alors d'excellente qualité.

Au cours d'une étape suivante on enlève ensuite la couche 3 et on obtient des éléments en semiconducteur en GaAs en couches minces sur un substrat silicium.

Une variante de la technique consiste à introduire directement dans le réacteur d'épitaxie la structure représentée sur la figure 3c. L'attaque de la couche 2 en GaAs à travers les ouvertures 4 pratiquées dans la couche 3 de $Si_3N_4$ s'effectue alors in situ, par du gaz chlorhydrique HCl, soit généré par décomposition de $AsCl_3$ dans le cas d'un réacteur trichlorure (il faut alors disposer d'une ligne d'$AsCl_3$ supplémentaire, ne transitant pas par la charge de Ga) soit directement injecté à partir d'une bouteille dans le cas d'un réacteur MOCVD. La structure obtenue après cette attaque in situ est identique à celle de la figure 3d. Les étapes ultérieures restent inchangées.

On observera toutefois que la région centrale de la couche mince obtenue reste défectueuse, ce qui, selon les applications envisagées peut poser problème. La description qui va suivre permet de pallier cet inconvénient.

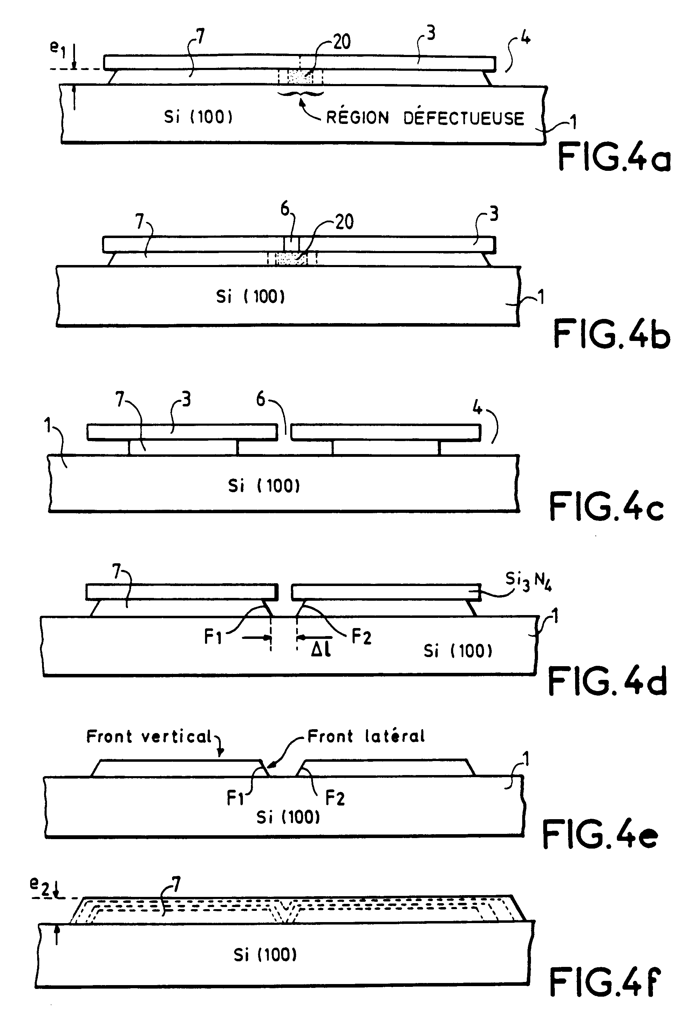

La situation de départ est schématisée en figure 4a. Elle résulte du procédé précédent, et on a volontairement arrêté la croissance épitaxiale dans l'espace de confinement 5 avant d'atteindre l'ouverture 4 afin d'éviter les débordements.

On continue le procédé en ouvrant, dans la couche 3, une fenêtre 6 parallèle aux bords de la couche et cela au dessus de la zone du germe 20 (figure 4b) et l'on élimine par attaque chimique (à l'aide par exemple de $H_2O_2$, $H_2SO_4$) la région du germe et de GaAs défectueux (voir figure 4c). On peut aussi éliminer cette région défectueuse par une attaque in situ dans le réacteur d'épitaxie, de même que décrit précédemment.

On répète l'opération d'épitaxie sélective de façon à combler une partie du vide laissé par l'attaque du cristal défectueux (figure 4d). On arrête cette opération d'épitaxie sélective lorsque les deux fronts de croissance $F_1$ et $F_2$ à l'endroit où se trouvait auparavant le cristal défectueux sont distants de $\Delta 1 = 1 \mu m$ environ (valeur typique mais non limitative).

On élimine ensuite la couche 2 de $Si_3N_4$ (par attaque HF par exemple) de façon à obtenir la structure de la figure 4.e.

Si les différentes bandes ont été orientées à 22,5° de la direction ⟨110⟩ comme précédemment indiqué, on observe pour GaAs, un rapport de l'ordre de 4 entre la vitesse de croissance du front latéral et la vitesse de croissance du front vertical (ici le plan (100) de la surface). Dans ces conditions, si la distance $\Delta 1$ entre les fronts $F_1$ et $F_2$ - (figure 4e) a été maintenue faible (typiquement 1 $\mu m$ comme indiqué précédemment), on peut faire rejoindre ces deux fronts en réalisant une croissance verticale faible (typiquement de l'ordre de $\Delta 1/8$ = 0,125 $\mu m$, pour un espacement originel de l'ordre de 1 = 1 $\mu m$ entre $F_1$ et $F_2$).

Ainsi, si l'on désire obtenir une couche mince d'épaisseur finale $e_2$, on choisira l'épaisseur $e_1$ - (voir figure 4a) de départ de façon telle que $e_1 = e_2 - \Delta 1/8$, ce qui impose la condition supplémentaire $\Delta 1 < 8e_2$ lors de l'étape de lithographie de la figure 4b conduisant à la gravure de la couche 3 de $Si_2{}_{N4}$ au dessus de la zone défectueuse. On obtient ainsi une couche 7 d'un matériau semiconducteur monocristallin exempt de défauts d'un certain type (GaAs selon l'exemple pris) sur un matériau semiconducteur d'un autre type (silicium selon l'exemple pris).

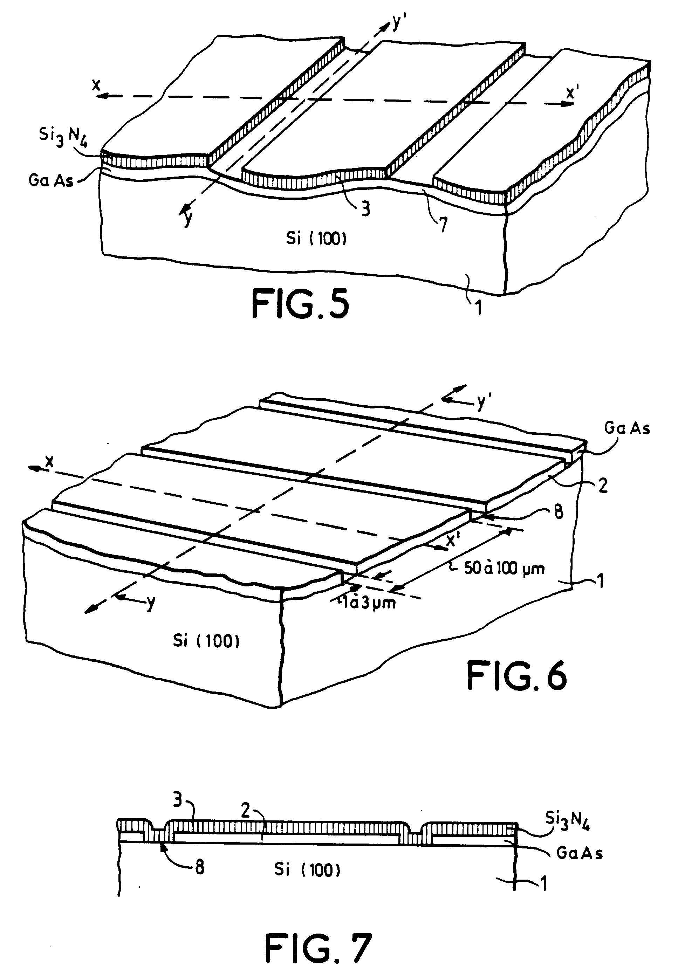

On a considéré que la dimension des bandes dans le sens parallèle aux ouvertures telles que 4 était limitée uniquement par la taille du substrat. La situation est résumée sur la figure 5 où, dans le sens de l'axe yy', la dimension des bandes résultant de la gravure dans la couche 3 de nitrure n'est pas limitée (ou n'est limitée que par la dimension du substrat). En fait, on peut avoir intérêt à limiter selon l'axe yy' les zones de germination de GaAs afin de diminuer les contraintes de refroidissement (dues aux différences de coefficient de dilatation thermique entre GaAs et Si) dans la bande de germination 20, où le cristal de GaAs a été nucléé sur le substrat Si lors de l'opération préalable MBE ou MOCVD. Ces contraintes pourraient entraîner par exemple une ondulation de l'extrémité des films de GaAs après croissance forcée.

Selon une variante du procédé de l'invention, on commence donc par graver des bandes d'isolement 8 dans la couche 2 (GaAs) hétéroépitaxié sur le substrat.

Le pas de répétition de ces bandes d'isolement 8 est typiquement de 50 à 100 $\mu m$ et la largeur de ces bandes est typiquement de 1 à quelques micromètres (voir figure 6). Ces bandes sont orientées comme précédemment de préférence à environ 22,5° d'une direction ⟨110⟩ ou ⟨1$\bar{1}$0⟩ (selon xx' sur la figure 6 ).

On dépose ensuite la couche 3 de $Si_3N_4$ sur la surface précédemment gravée. La figure 7 représente une coupe selon yy' après dépôt de cette couche 3 de $Si_3N_4$.

L'épaisseur typique de la couche 3 de $Si_3N_4$ est de 0,5 à 1 $\mu m$.

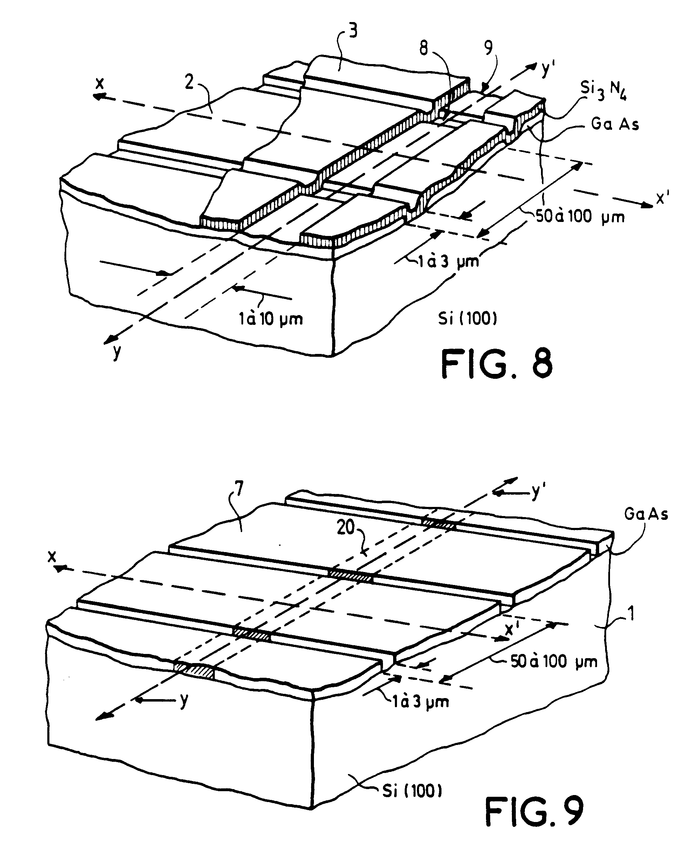

De même que sur la figure 3c, on grave dans la couche 3 de $Si_3N_4$ un deuxième système de bandes 9, qui peut être de préférence perpendiculaire aux premières bandes, c'est-à-dire perpendiculaire aux gravures 8 comme cela est représenté en figure 8.

Ces bandes font typiquement de 1 à 10 $\mu m$ de largeur et leurs pas de répétitions est de quelques dizaines à quelques centaines de microns.

On répète ensuite les opérations décrites en relation avec les figures 3d et 3e, figures que l'on peut à présent considérer comme des coupes de la figure 8 selon l'axe xx'.

On obtient ainsi après croissance forcée et retrait de la couche 3 des pavés de GaAs sans défauts hormis la zone centrale de germination 20 (figure 9). Le germe 20 et la bande de défauts peut être éliminé selon le même type d'opérations que décrit en relation avec la figure 4.

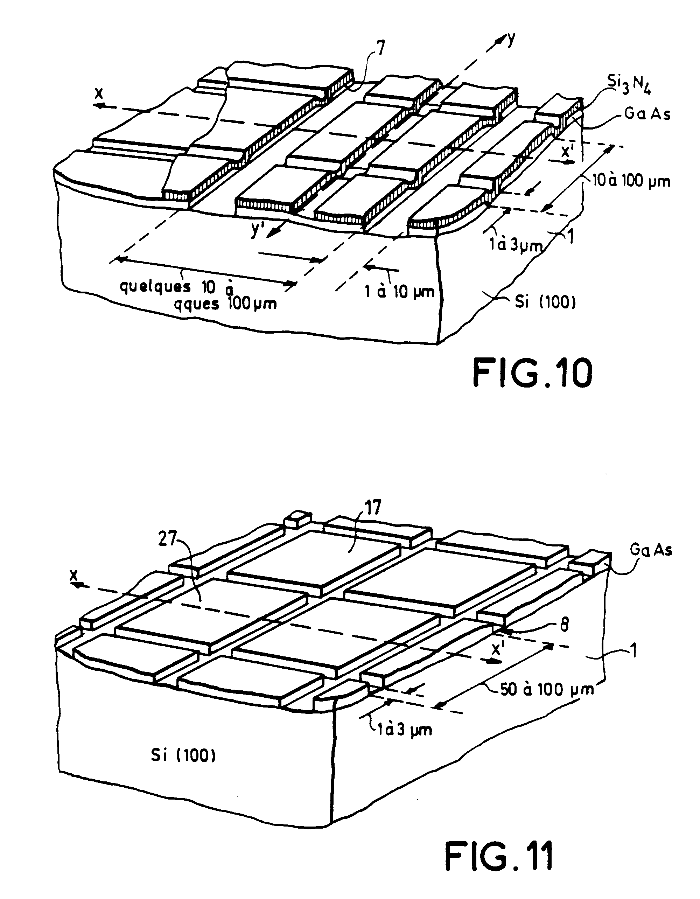

Pour cela comme est représenté en figure 10 avant le retrait de la couche 3, on réalise dans la couche 3, une gravure de bandes 6 selon une direction yy' de façon à pratiquer une ouverture au dessus de chaque germe 20. Cette opération correspond à celle de la figure 4b. Ensuite comme cela a été décrit en relation avec la figure 4c, on réalise une attaque chimique des germes 20 et des parties défectueuses de semiconducteur. Puis on effectue une épitaxie du même matériau que les bandes 7 (GaAs), on enlève la couche de $Si_3N_4$ eton obtient des pavés de matériau semiconducteur tels que représentés en figure 11 en matériau semiconducteur sans défaut.

On peut ensuite éventuellement effectuer une croissance de matériau semiconducteur (GaAs) sur les pavés tels que 17 et 27 (de façon similaire à ce qui a été fait en figure 4f) de façon à réunir deux pavés 17 et 27.

Selon l'invention, on peut également moduler la composition la couche 15 épitaxiée ou prévoir un dopage de la couche (dopage d'un même type modulé ou non, ou bien dopages de différents types) comme cela est décrit dans la demande de brevet français n° 89 04257 déposée le 31 mars 1989.

On peut également utiliser la couche 15 obtenue comme substrat de départ pour une épitaxie suivante et ainsi de suite pour obtenir une superposition de couches épitaxiées voire même une superposition de composants situés dans des plans différents.

Le procédé de l'invention peut être appliqué à la réalisation de couches minces monocristallines de matériaux semiconducteurs sur isolants amorphes ou polycristallins. Il peut permettre la réalisation de structures particulières (transistor à effet de champ à double grille, transistors à base perméable, hétéro- structures et super-réseaux latéraux etc ...).

Le procédé de l'invention permet ainsi de réaliser des croissance avec des semiconducteurs de nature différentes et d'obtenir des structures hétéroépitaxiales dans lesquelles les différentes couches sont néanmoins monocristallines et ne présentent pas de dislocation ni de plans de défauts.

**Revendications**

1. Procédé de réalisation par croissance en phase vapeur sur un substrat en matériau semiconducteur d'un premier type d'une couche mince monocristalline d'un matériau semiconducteur d'un deuxième type, caractérisé en ce que la croissance est initiée sur au moins un germe (20) de composition chimique identique au matériau semiconducteur du deuxième type de la couche mince à obtenir, et est confinée dans un espace (5) défini par une face du substrat 1 lui-même et une couche de confinement (3) en matériau différent du matériau semiconducteur du deuxième type de telle façon qu'il ne peut y avoir ni nucléation ni dépôt de matériau semiconducteur sur cette couche de confinement (3) ni sur ladite face du substrat (1), l'espace de confinement (5) définissant l'épaisseur de la couche mince monocristalline de semiconducteur à obtenir.

2. Procédé de réalisation selon la revendication 1, caractérisé en ce que le germe (20) est compris dans l'espace de confinement (5).

3. Procédé de réalisation selon la revendication 1, caractérisé en ce qu'il comporte les étapes suivantes :
   a) une première étape de réalisation sur le substrat (1) semiconducteur monocristallin d'une première couche (2) d'un matériau semiconducteur du deuxième type ;
   b) une deuxième étape de réalisation sur la première couche (2) de la couche de confinement (3) en matériau tel qu'il ne peut y avoir ninucléation, ni dépôt d'un matériau du deuxième type ;
   c) une troisième étape de gravure dans la deuxième couche (3) d'au moins une première ouverture (4) aboutissant sur la première couche de matériau semiconducteur (2) ;
   d) une quatrième étape d'attaque chimique à partir de ladite ouverture de la première couche (2) de matériau semiconducteur de façon à laisser au moins un germe (20) de matériau semiconducteur du deuxième type entre la deuxième couche (3) et le substrat (1) et à constituer un espace de confinement (5) ;
   e) une cinquième étape de croissance par épitaxie en phase vapeur d'un matériau semiconducteur monocristallin du deuxième type dans l'espace de confinement (5), cette croissance étant réalisée selon une première direction de croissance.

4. Procédé selon la revendication 3, caractérisé en ce qu'il comporte une sixième étape de retrait de la couche de confinement (3).

5. Procédé selon la revendication 3, caractérisé en ce que la cinquième étape de croissance par épitaxie en phase vapeur est suivie d'une étape de gravure d'au moins une deuxième ouverture (6) dans la deuxième couche (3) à un emplacement situé au dessus du germe (20), puis d'une étape d'attaque chimique, par la deuxième ouverture (6), réalisée du germe (20) et de toute partie de matériau semiconducteur située de part et d'autre du germe (20) et présentant des défauts.

**6.** Procédé selon la revendication 5, caractérisé en ce qu'il comporte à la suite des étapes suivantes, une étape d'épitaxie en phase vapeur d'un matériau du deuxième type par la deuxième ouverture (6).

**7.** Procédé selon la revendication 6, caractérisé en ce qu'il comporte à la suite de l'étape indiquée, une étape d'enlèvement de la deuxième couche (3) suivie d'une étape d'épitaxie en phase vapeur.

**8.** Procédé selon la revendication 3, caractérisé en ce que la deuxième étape est précédée d'une étape de gravure dans la première couche (2) de bandes (8) constituant des interruptions dans la première couche (2) et que la bande de la première ouverture (4) réalisée lors de la troisième étape de gravure n'est pas parallèle à ces bandes (8) pratiquées dans la première couche (2).

**9.** Procédé selon la revendication 8, caractérisé en ce que la bande de la première ouverture (4) est perpendiculaire aux bandes (8) pratiquées dans la première couche (2).

**Claims**

**1.** Method of production, by vapour phase growth on a substrate made of semiconductor material of a first type, of a monocrystalline thin layer of a semiconductor material of a second type, characterized in that the growth is initiated on at least one seed (20) of chemical composition identical to the semiconductor material of the second type of the thin layer to be obtained and is confined in a space (5) defined by one face of the substrate (1) itself and a confinement layer (3) made of material different from the semiconductor material of the second type in such a way that it is not possible to have either nucleation or deposition of semiconductor material on this confinement layer (3) or on the said face of the substrate (1), the confinement space (5) defining the thickness of the monocrystalline thin layer of semiconductor to be obtained.

**2.** Method of production according to Claim 1, characterized in that the seed (20) lies within the confinement space (5).

**3.** Method of production according to Claim 1, characterized in that it includes the following steps:
a) a first step of production, on the monocrystalline semiconductor substrate (1), of a first layer (2) of a semiconductor material of the second type;
b) a second step of production, on the first layer (2), of the confinement layer (3) made of material such that it is not possible to have either nucleation or deposition of a material of the second type;
c) a third step of etching, in the second layer (3), of at least one first opening (4) terminating on the first layer (2) of semiconductor material;
d) a fourth step of chemical etching, from the said opening, of the first layer (2) of semiconductor material so as to leave at least one seed (20) of semiconductor material of the second type between the second layer (3) and the substrate (1) and to form a confinement space (5);
e) a fifth step of growth, by vapour phase epitaxy, of a monocrystalline semiconductor material of the second type in the confinement space (5), this growth being carried out along a first growth direction.

**4.** Method according to Claim 3, characterized in that it includes a sixth step of removal of the confinement layer (3).

**5.** Method according to Claim 3, characterized in that the fifth step of growth by vapour phase epitaxy is followed by a step of etching of at least one second opening (6) in the second layer (3) at a point located above the seed (20) and then by a step of chemical etching, via the second opening (6), carried out of the seed (20) and the entire part of the semiconductor material located on either side of the seed (20) and having defects.

**6.** Method according to Claim 5, characterized in that it includes, after the following steps, a step of vapour phase epitaxy of a material of the second type via the second opening (6).

**7.** Method according to Claim 6, characterized in that it includes, following the step indicated, a step of removal of the second layer (3) followed by a vapour phase epitaxy step.

**8.** Method according to Claim 3, characterized in that the second step is preceded by a step of etching, in the first layer (2), of bands (8) forming interruptions in the first layer (2) and in that the band of the first opening (4) produced during the third etching step is not parallel to these bands (8) made in the first layer (2).

9. Method according to Claim 8, characterized in that the band of the first opening (4) is perpendicular to the bands (8) made in the first layer (2).

**Patentansprüche**

1. Verfahren zur Erzeugung einer dünnen monokristallinen Schicht eines Halbleitermaterials eines zweiten Typs durch Aufwachsen aus der Dampfphase auf einem Substrat aus einem Halbleitermaterial eines ersten Typs, dadurch gekennzeichnet, daß das Aufwachsen an mindestens einem Keim (20) einer gleichen chemischen Zusammensetzung wie das Halbleitermaterial des zweiten Typs der zu erzielenden dünnen Schicht beginnt und auf einen durch eine Seite des Substrats (1) selbst und eine Einschließungsschicht (3) eines sich vom Halbleitermaterial des zweiten Typs unterscheidenden Materials definierten Raum (5) begrenzt wird, so daß keine Keimbildung und keine Abscheidung von Halbleitermaterial auf dieser Einschließungsschicht (3) oder auf der erwähnten Seite des Substrats (1) erfolgen kann, wobei der Einschließungsraum (5) die Dicke der zu erhaltenden monokristallinen dünnen Halbleiterschicht definiert.

2. Verfahren nach Anspruch 1, dadurch gekennzeichnet, daß der Keim (20) sich im Einschließungsraum (5) befindet.

3. Verfahren nach Anspruch 1, dadurch gekennzeichnet, daß es folgende Verfahrensschritte enthält:
   a) einen ersten Verfahrensschritt, in dem auf das monokristalline Halbleitersubstrat (1) eine erste Schicht (2) eines Halbleitermaterials des zweiten Typs aufgebracht wird,
   b) einen zweiten Verfahrensschritt, in dem auf die erste Schicht (2) die Einschließungsschicht (3) aus einem solchen Material aufgebracht wird, daß dort weder Keimbildung noch die Abscheidung eines Materials des zweiten Typs erfolgt,
   c) einen dritten Verfahrensschritt, in dem in der zweiten Schicht (3) mindestens eine erste Öffnung (4) ausgeätzt wird, die bis auf die erste Schicht aus Halbleitermaterial (2) reicht,
   d) einen vierten Verfahrensschritt, in dem durch die Öffnung die erste Schicht (2) aus Halbleitermaterial so abgeätzt wird, daß mindestens ein Keim (20) aus dem Halbleitermaterial des zweiten Typs zwischen der zweiten Schicht (3) und dem Substrat (1) verbleibt, wodurch der Einschließungsraum (5) gebildet wird,
   e) einen fünften Verfahrensschritt, in dem durch epitaxiales Wachstum aus der Dampfphase ein monokristallines Halbleitermaterial des zweiten Typs im Einschließungsraum (5) abgeschieden wird, wobei dieses Wachstum gemäß einer ersten Wachtumsrichtung erfolgt.

4. Verfahren nach Anspruch 3, dadurch gekennzeichnet, daß es einen sechsten Verfahrensschritt aufweist, bei dem die Einschließungsschicht (3) entfernt wird.

5. Verfahren nach Anspruch 3, dadurch gekennzeichnet, daß dem fünften Verfahrensschritt des epitaxialen Aufwachsens aus der Dampfphase ein Verfahrensschritt folgt, in dem mindestens eine zweite Öffnung (6) in der zweiten Schicht (3) an einer Stelle ausgeätzt wird, die oberhalb des Keims (20) liegt, worauf ein Verfahrensschritt folgt, in dem durch die zweite Öffnung (6) hindurch der Keim (20) und alle Bereiche des fehlerhaften Halbleitermaterials zu beiden Seiten des Keims (20) chemisch entfernt werden.

6. Verfahren nach Anspruch 5, dadurch gekennzeichnet, daß danach ein Verfahrensschritt folgt, in dem aus der Dampfphase ein Material des zweiten Typs durch die zweite Öffnung (6) epitaxial abgeschieden wird.

7. Verfahren nach Anspruch 6, dadurch gekennzeichnet, daß nach dem angegebenen Verfahrensschritt ein Verfahrensschritt folgt, in dem die zweite Schicht (3) entfernt wird, und ein Verfahrensschritt, in dem ein epitaxiales Aufwachsen aus der Dampfphase erfolgt.

8. Verfahren nach Anspruch 3, dadurch gekennzeichnet, daß dem zweiten Verfahrensschritt ein Verfahrensschritt vorausgeht, in dem in der ersten Schicht (2) Bänder (8) ausgeätzt werden, die Unterbrechungen in der ersten Schicht bilden, und daß das Band der ersten Öffnung (4), das während des dritten Verfahrensschritts durch Ätzen gebildet wurde, nicht zu diesen in der ersten Schicht (2) ausgebildeten Bändern (8) parallel verläuft.

9. Verfahren nach Anspruch 8, dadurch gekennzeichnet, daß das Band der ersten Öffnung (4) senkrecht zu den in der ersten Schicht (2) ausgebildeten Bändern (8) verläuft.

DIELECTRIQUE 2    DIELECTRIQUE 1
GERME                ($Si_3N_4$)        OUVERTURE
DE GaAs

GAZ ⟵    ⟶ GAZ

GaAs

SUBSTRAT  Si (100)  désorienté

ETAT  DE  LA  TECHNIQUE
# FIG.1

DIELECTRIQUE    1 NIVEAU  DE  MASQUAGE
20                                    20'      3

⟶ CROISSANCE  FORCEE

Si  (100)  désorienté

GERME    DE    GaAs                    1

# FIG. 2

FIG.3a

FIG.3b

FIG.3c

BANDE DE GERMINATION

FIG.3d

FIG.3e

BLOCAGE DES DÉFAUTS

FRONT DE CROISSANCE

FIG.3f

$e_1$ ↓

7          20          3          4

Si (100)          RÉGION DÉFECTUEUSE          1

**FIG.4a**

7          6          20          3

Si (100)          1

**FIG.4b**

7          3          6          4

1

Si (100)

**FIG.4c**

7          $Si_3N_4$

$F_1$          $F_2$          1
$\Delta l$          Si (100)

**FIG.4d**

Front vertical          Front latéral

1

$F_1$          $F_2$
Si (100)

**FIG.4e**

$e_2$ ↓          7

Si (100)

**FIG.4f**

FIG.5

FIG.6

FIG. 7

FIG. 8

FIG. 9

FIG.10

FIG.11